# EUROPEAN PATENT APPLICATION

(11) **EP 0 578 880 A1**
(43) Date of publication of application: **19.01.1994**
(21) Application number: 92306454.7
(22) Date of filing: 14.07.1992
(51) Int. Cl.: H01R 13/03, H01R 13/658

(54) **Plated D-shell connector**

(71) Applicant: GENERAL ELECTRIC COMPANY, Schenectady, NY 12345 (US)
(72) Inventor: Zaderej, Victor Vasyl, Branford, Connecticut 06405 (US); Betters, James Edward, Newburgh, Indiana 47630 (US)
(74) Representative: Pratt, Richard Wilson

(57) **Abstract**

A female D-shell connector is fabricated by molding a portion of a three dimensional circuit board into a D-shaped block having a plurality of plated through holes passing through the block. The holes are arranged in two staggered rows having a relief channel passing between the rows so that the circuit board may flex to provide spring pressure against mating pins of a male connector. A mating male connector may be similarly fabricated by molding a D-shaped wall encircling a plurality of plated through holes. Pins are installed in the through holes in a secondary process.

## Description

### CROSS REFERENCE TO RELATED APPLICATIONS

This application is related to the following patent applications filed simultaneously herewith which are incorporated herein by reference: "Plated Electrical Connectors", to Victor Zaderej et al., docket number JM-8911; "Three Dimensional Plating Or Etching Process and Masks Therefor", to John Mettler et al., Docket number JM-8916; "Audio Jack Connector", to Victor Zaderej et al., Docket number JM-8918; and "Circuit Board Edge Connector", to Victor Zaderej et al., Docket number JM-8919.

### BACKGROUND

### Field of the Invention

This invention relates generally to the field of electrical connectors. More particularly, this invention relates to an improved D-shell type connector or similar which is manufactured by molding and plating.

### Background of the Invention

The term "D-shell connector" is used generically herein to embrace any of a number of connectors which are commonly referred to in the electronics industry by this name as well as similar names such as "D connector" or "D-type connector" such as those available from AMP, Incorporated, Harrisburg, PA. In general, they are characterized by an approximately D-shaped wall or shell surrounding a plurality of pins in the male connector. The female connector includes a matching number of apertures to accept the male connector pins, the apertures being formed in a mating D- shaped insulator. While the preferred embodiment of the present invention is specifically directed toward a D-shell connector, other connectors which do not specifically use a D-shaped block and wall may also be fabricated according to the present invention.

The D-shell connector has become a popular industry standard electrical connector which is available in many variations for many applications. With the growing prevalence of the personal computer, the D-shell connector has become even more popular in it's use to interconnect peripheral devices to the personal computer. Many other uses for the connector can also be found in industry.

One popular version, for example, includes a plurality of solderable pins extending from the rear of the connector. These pins are inserted through mating holes in a printed wiring board (PWB) to permit interconnection with a mating connector which may either similarly be mated to a printed wiring board or may form the connector termination of a wiring harness or cable.

In such arrangements, the connector is typically further mechanically secured to the PWB by use of a pair of screws and a set of spacer bushings. Unfortunately, such an arrangement is not as space efficient as it could be since the connector protrudes unnecessarily high from the printed wiring board. In addition, installation of such a connector must generally be performed as a manual or secondary operation, thus increasing manufacturing costs of the end product.

The present invention ameliorates such problems by providing an improved D-shell connector which may be molded as a part of a printed wiring board or other plastic panel.

### SUMMARY OF THE INVENTION

It is an object of the present invention to provide an improved D-shell connector.

It is another object of the present invention to provide a D- shell connector which may be fabricated as a unitary part with a printed wiring board or plastic panel.

It is an advantage of the invention that the molded connector has fewer parts than typical connectors and may be made to have a lower profile.

These and other objects and advantages of the invention will become apparent to those skilled in the art upon consideration of the following description of the invention.

A male electrical connector according to one embodiment of the present invention includes an insulative planar substrate including a plurality of conductive plated through holes. A wall extends upward from the planar substrate to encircle the plated through holes. A plurality of conductive pins are connected to the plated through holes and extend upward inside the wall. A conductive plating may be applied to an outer or inner surface of the wall.

A female electrical connector according to an embodiment of the present invention includes an insulative planar substrate with an insulative block extending upward from the planar substrate. A plurality of plated passages extend through the block and the substrate. A springing arrangement causes the plated passages to exert spring pressure toward a center of each passage. The springing arrangement may comprise a slot passing between the two rows of passages so that the plated passages include a wall adjacent the slot and the wall flexes to provide a portion of the spring pressure.

A female D-shell electrical connector according to one embodiment of the present invention, includes an insulative planar substrate forming a part of a printed wiring board with an approximately D-shaped insulative block extending upward from the planar substrate. A plurality of plated passages arranged in two rows extend through the block and the substrate. A springing arrangement causes the plated passages to exert spring pressure toward a center of each passage. The springing arrangement may comprise a slot passing between the two rows of passages so that the plated passages include a wall adjacent the slot and the wall flexes to provide a portion of the spring pressure.

In another aspect of the present invention, an apparatus for receiving male pins in a printed wiring board includes an insulative substrate having an upper surface and a lower surface. An insulative block is disposed on the upper surface and has a top surface. A first row of passages having passage walls passes from the top surface of the block to a predetermined depth. A second row of passages having passage walls passes from the top surface of the block to the predetermined depth. A relief channel is disposed between the first and second rows of passages to permit flexing of the passage walls when male pins are inserted within the passages. Preferably, the passages are tapered and the channel extends upward from the lower surface to a point beyond the predetermined depth.

According to the present invention, a female D-shell connector is fabricated by molding a portion of a three dimensional circuit board into a D-shaped block having a plurality of plated through holes passing through the block. The holes are arranged in two staggered rows having a relief channel passing between the rows so that the circuit board may flex to provide spring pressure against mating pins of a male connector. A mating male connector may be similarly fabricated by molding a D-shaped wall encircling a plurality of plated through holes. Pins are installed in the through holes in a secondary process.

The features of the invention believed to be novel are set forth with particularity in the appended claims. The invention itself, however, both as to organization and method of operation, together with further objects and advantages thereof, may be best understood by reference to the following description taken in conjunction with the accompanying drawing.

### BRIEF DESCRIPTION OF THE DRAWING

FIGURE 1 is a perspective view of a female D-shell connector according to the present invention.

FIGURE 2 shows a bottom view of the female D-shell connector of FIGURE 1.

FIGURE 3 shows a side view of the female D-shell connector of FIGURE 1.

FIGURE 4 is a sectional view of the female D-shell connector of FIGURE 1 taken along lines A-A.

FIGURE 5 is a perspective view of a male D-shell connector according to the present invention.

FIGURE 6 is a side view of the male D-shell connector shown in FIGURE 5 without the pins or pin holes.

FIGURE 7 is a sectional view of the male D-shell connector of FIGURE 5 taken along lines B-B.

### DETAILED DESCRIPTION OF THE INVENTION

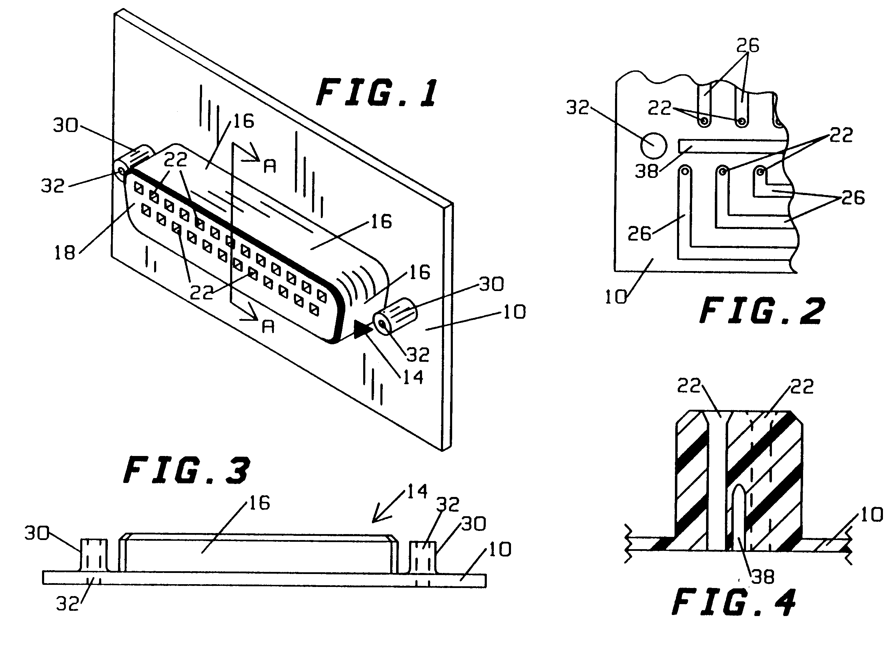

Turning now to the drawing in which like reference numerals designate corresponding parts throughout the several figures thereof, and in particular to FIGURE 1, a female D-shell connector according to the present invention is shown. A planar substrate 10 is molded as an integral portion of the connector and may be for example a printed wiring board (PWB). The substrate includes an approximately D-shaped block 14 extending from a surface thereof. The outer side surfaces 16 of the block 14 may be plated with a conductive material by a process such as that disclosed in the above application to Mettler et al or other appropriate process. This D-shaped block 14 will have essentially the dimensions of one of the many variations of a standard female D-shell connector. The block 14 includes a top surface 18 which is essentially free of conductive plating.

Top surface 18 carries a plurality of plated through holes such as 22 extending from this top surface 18 to the bottom of the substrate. In the illustrated example, 25 such plated through holes are shown, but this is not to be limiting since many standard and non-standard conductor numbers are possible. The plated through holes 22 of the present invention are connected to plated conductors 26 on the lower surface of the printed wiring board substrate 10 as shown in FIGURE 2. These plated through holes 22 may thus be connected to electrical circuit components disposed on the circuit board as required or may be attached to wires via these conductors in a conventional manner.

When D-shell connectors are mated together, they are frequently secured into place by a screw connection. To permit such connection, frequently stand-offs are placed between the connectors to facilitate a good mechanical fit which will not place undue stresses on the mating pins. A pair of integral stand-offs 30 having a screw hole 32 passing therethrough may be provided as an integral molded part of the substrate 10.

A side view of the connector of FIGURE 1 is shown in FIGURE 3. In order to provide ease of registration of the female connector with the male connector, the junction of the sides 16 with the upper surface 18 may be chamfered at 45°. Similarly, as shown in FIGURE 4, the through holes 22 may have a funnel shape at the top. In the embodiment shown, the topmost portion of the through hole 22 is square in cross section and is formed that way in the molding process. The remainder of the through holes 22 are also square in cross section but may be round to more closely conform with the shape of the mating pin of the male connector. This shape is of course not to be limiting since a round or oval cross section hole or other shape could also be used. Holes 22 may be tapered slightly from top to bottom so that the springs are gradually loaded as a male connector is inserted. In the preferred embodiment, this taper is from about 0.032 to about 0.026 inches

The contact forces between the male pin and the female plastic spring are set by the tolerances between the two mating parts through the range of tolerances. For this connector, the contact forces are designed to provide between approximately 150 and 500 grams of normal force. Tighter tolerances may be used to narrow this range if desired. Furthermore, the design preferrably limits the displacement of the plastic material to a degree which prevents the plastic material from experiencing significant stress.

Referring to FIGURE 4 in conjunction with FIGURE 2, a channel 38 is molded or cut between the two rows of apertures 22 to provide relief in the plastic substrate to permit it to flex somewhat when pins are inserted into the through holes 22. This relief channel 38 allows the plastic walls of the through holes 22 to flex and act as springs to tightly compress the mating pins of the male connector.

In the 25 pin connector shown in FIGURE 1, the two rows of through holes 22 are separated by approximately 0.112 inch. Adjacent through holes 22 in the rows are separated by approximately 0.109 inch and opposing holes in each row are staggered. The relief channel 38 is approximately 0.036 inch wide and approximately 0.178 inch deep. The preferred material for use in making the substrate is General Electric Ultem 2312. Of course, these materials and measurements are not intended to be limiting, but rather illustrative. Other materials and dimensions may prove suitable.

While these dimensions, as well as other dimensions disclosed herein, are not intended to be limiting, they provide for a good mate with commercially available D-shell connectors. The dimensions disclosed are for the unplated plastic part and assume that a plating thickness of approximately 0.0015 inches will be deposited on the part.

The outside layer of metalization within the female connector may be copper, nickel, gold or a variety of other materials. The outside surface of the connector may be plated with a variety of materials also but is preferrably plated with nickel to provide a durable, abrasion resistant surface.

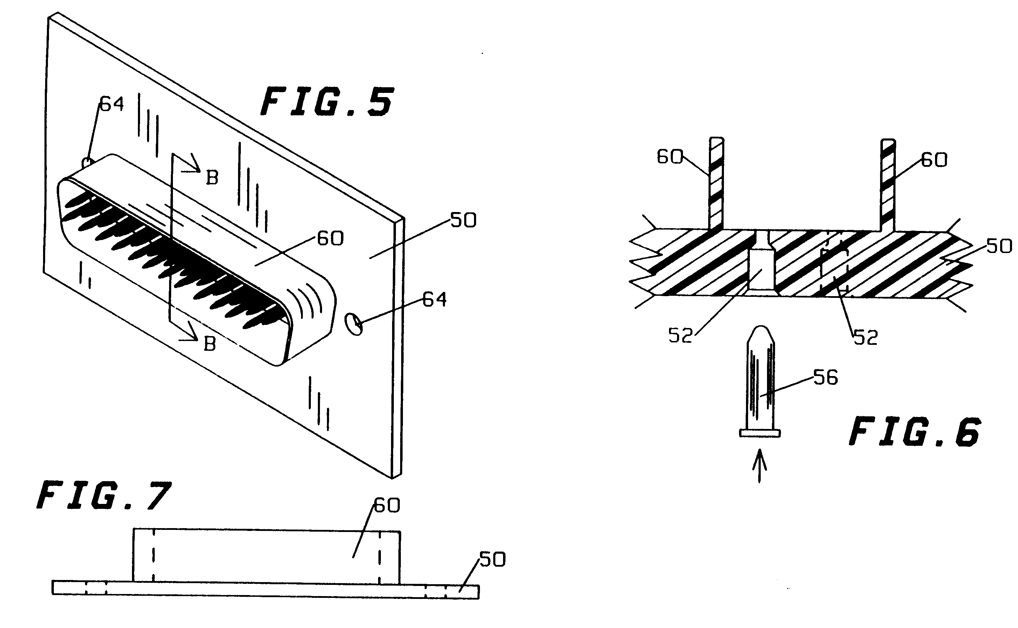

Turning now to FIGURE 5, viewed in conjunction with FIGURE 6, a male D-shell connector according to the present invention is shown. A planar substrate 50 which may be a printed wiring board includes a plurality of plated through holes 52 which are fitted with commercially available or custom made metal pins 56. Such pins 56 are installed as a secondary operation by press fitting the pins 56 into the plated through holes 52 in a known manner. Through holes 52 preferrably include a wider tapered area adjacent the lower surface of the substrate and a narrower portion near the upper surface of the substrate. This forms a compliant contact surface for the pin 56 reducing or eliminating the need for the pin 56 to be soldered into place. These through holes 52 are arranged in two staggered rows to match the mating female connector as shown in FIGURE 1. The two rows of through holes are surrounded by a D-shaped wall 60 which is suitably dimensioned to mate outside the D-shaped block of the mating female connector. The inner and / or the outer surfaces of the D-shaped wall 60 may be plated with a shield conductor if desired according to the process described in the above John Mettler et al. application.

The bottom and / or top surface of the substrate 50 may be plated in a manner similar to that of substrate 10 to form a part of a printed wiring board. In any event, the plated through holes 52 are electrically connected to plated conductors on the lower surface of the substrate 50 to make appropriate electrical contact with the pins 56.

The substrate 50 may be provided with screw holes 64 which align with screw holes 32 of stand offs 30 in the female connector.

Those skilled in the art will appreciate that there are many variations possible with the present invention without departing from the present invention. For example, varying of the shape of the block and wall, number of pins and sockets, materials used and patterns of shield plating may be introduced without departing from the present invention.

Thus it is apparent that in accordance with the present invention, an improved apparatus and method that fully satisfies the objectives, aims and advantages is set forth above. While the invention has been described in conjunction with specific embodiments, it is evident that many alternatives, variations, modifications and permutations will become apparent to those skilled in the art in light of the foregoing description. Accordingly, it is intended that the present invention embrace all such alternatives, variations, modifications and permutations as fall within the scope of the appended claims.

## Claims

1. A male electrical connector, comprising in combination:
an insulative planar substrate including a plurality of conductive plated through holes;
a wall extending from said planar substrate to encircle said plated through holes;
a plurality of conductive pins connected to said plated through holes and extending inside said wall.

2. The apparatus of claim 1, further comprising a conductive plating covering an outer surface of said wall.

3. The apparatus of Claim 1 or Claim 2, wherein said wall includes an upper end and a lower end, and further comprising means defining an aperture passing through said substrate adjacent each of said upper and lower ends.

4. A female electrical connector, comprising in combination:
an insulative planar substrate;
an insulative block extending from said planar substrate;
a plurality of plated passages extending through said block and said substrate.

5. The apparatus of claim 4, further comprising springing means for causing said plated passages to exert spring pressure toward a center of each passage.

6. The apparatus of Claim 4 or Claim 5, wherein said block includes an upper end and a lower end, and further comprising standoff means adjacent each of said upper and lower ends.

7. The apparatus of claim 6, wherein said block includes an upper end and a lower end, and wherein said standoff means further comprises means defining an upwardly extending cylinder with an aperture passing therethrough and through said substrate adjacent each of said upper and lower ends.

8. The apparatus of any one of Claims 4 to 7, wherein said passages are funnel shaped so that said passage narrows in diameter as it approaches said substrate.

9. A female D-shell electrical connector, comprising in combination:
an insulative planar substrate forming a part of a printed wiring board;
an approximately D-shaped insulative block extending upward from said planar substrate;
a plurality of plated passages arranged in two rows and extending through said block and said substrate; and
springing means for causing said plated passages to exert spring pressure toward a center of each passage, said springing means comprising a slot passing between said two rows of passages so that said plated passages include a wall adjacent said slot and said wall flexes to provide a portion of said spring pressure.

10. An apparatus for receiving male pins in a printed wiring board, comprising in combination:
an insulative substrate having an upper surface and a lower surface;
an insulative block disposed on said upper surface and having a top surface;
a first row of passages having passage walls and passing from said top surface of said block to a predetermined depth;
a second row of passages having passage walls and passing from said top surface of said block to said predetermined depth; and
a relief channel means disposed between said first and second rows of passages to permit flexing of said passage walls when male pins are inserted within said passages.
